## Europäisches Patentamt

## European Patent Office

## Office européen des brevets

(11) Veröffentlichungsnummer: **0 305 696 B1**

# EUROPÄISCHE PATENTSCHRIFT

(45) Veröffentlichungstag der Patentschrift: **29.07.92**

(21) Anmeldenummer: **88111249.4**

(22) Anmeldetag: **13.07.88**

(51) Int. Cl.5: **H05K 13/00**, B23K 1/00, H05K 3/34

(54) **Verfahren zum Auslöten von aufgeklebten SMD-Bauteilen.**

(30) Priorität: **31.08.87 DE 3729016**

(43) Veröffentlichungstag der Anmeldung:
**08.03.89 Patentblatt 89/10**

(45) Bekanntmachung des Hinweises auf die
Patenterteilung:
**29.07.92 Patentblatt 92/31**

(84) Benannte Vertragsstaaten:
**AT BE CH DE FR GB IT LI NL SE**

(56) Entgegenhaltungen:
**EP-A- 0 233 018**
**DE-A- 2 453 022**
**US-A- 3 912 153**

**IBM TECHNICAL DISCLOSURE BULLETIN,
Band 26, Nr. 9, Februar 1984, Seiten
4780-4782, New York, US; A.R. FORMICHELLI
et al.: "Non-destructive torsional chip removal"**

**IBM TECHNICAL DISCLOSURE BULLETIN,
Band 30, Nr. 1, Juni 1987, Seiten 114-116,
New York, US; "Robotic hot air
solder/desolder placement device"**

(73) Patentinhaber: **SIEMENS AKTIENGESELL-
SCHAFT
Wittelsbacherplatz 2
W-8000 München 2(DE)**

(72) Erfinder: **Bunz, Georg
Jean-Paul-Richter-Strasse 23
W-8000 München 70(DE)**

## Beschreibung

Die Erfindung betrifft ein Verfahren zum Auslöten von aufgeklebten oberflächenmontierbaren Bauteilen mittels eines Lötkopfes, wobei zunächst über den Lötkopf die für die Aufschmelzung der Lötverbindung nötige Wärme zugeführt wird und im Anschluß daran das aufgeklebte Bauelement von einer Leiterplatte abgetrennt wird.

Bei der Fertigung von elektronischen Flachbaugruppen ist in der letzten Zeit ein Übergang von der herkömmlichen Technik der Einsteckmontage zur Technik der Oberflächenmontage von flach auflötbaren Bauelementen zu verzeichnen. Die hierbei eingesetzten oberflächenmontierbaren Bauelemente (SMD $\hat{=}$ Surface Mounted Devices) werden durch Bestückautomaten auf den Leiterplatten positioniert, meistens mittels mehrerer Klebstoffpunkte fixiert und anschließend durch ein übliches Lötverfahren verlötet, womit die elektrische Verbindung hergestellt ist. Die bei derartigen Verfahren auftretenden Fehler, sei es durch Einbau falscher oder defekter Bauelemente oder zum Beispiel durch falsche Positionierung, müssen in einem separaten Verfahren durch Auslöten der entsprechenden Bauelemente und entsprechender Korrektur durch fehlerfreies Einlöten von neuen Bauelementen beseitigt werden. Dies geschieht mittels Vorrichtungen, die man im allgemeinen als Ein- und Auslötmaschinen bezeichnet. Derartige auf dem Markt erhältliche Maschinen müssen einer Vielzahl von Qualitätsanforderungen genügen. So ist es erforderlich, daß der Platz eines defekten Bauelementes, welches ausgelötet und durch fehlerfreies Einlöten eines funktionsfähigen Bauelementes ersetzt werden soll, ohne Behinderungen und ohne Parallaxen-Fehler zu betrachten ist. Des weiteren muß die Heizeinrichtung, mit der die Anschlußbeine des Bauelementes zum Aus- oder Einlöten beheizt werden, eine gleichmäßige Temperaturverteilung über die verschiedenen Anschlußbeine aufweisen und darf zugleich den Körper des Bauelementes nicht zu sehr erhitzen. Ebenso werden hohe Anforderungen an die Ausrichtung des Bauelementes bezüglich der Leiterplatte und des einen Lötplatzes, an die exakte Dosierung von Lotpaste, an die Kühlung des Bauelementes nach dem Einlöten, sowie an die Handhabung eines durch den Bestückautomaten aufgeklebten Bauelementes beim Auslöten in der Ein- oder Auslötmaschine gestellt.

Das Auslöten von Bauelementen wird zum Teil dadurch erschwert, daß die verfahrensbedingte Fixierung der Bauelemente beim Einlöten mittels einem oder mehrerer Klebstoffpunkte auf der Leiterplatte das Bauteil trotz aufgeschmolzenem Lot an den Anschlußbeinen nicht freigibt und die Kraft, die durch eine Vakuumansaugeinrichtung erzeugt wird, nicht ausreicht, um das Bauteil von der Leiterplatte abzuheben.

Der Erfindung liegt die Aufgabe zugrunde, ein Verfahren zum Abtrennen von aufgeklebten Bauelementen beim Auslöten bereitzustellen, mit dem auch großflächige Klebungen oder solche mit mehreren Klebstoffpunkten gelöst werden können.

Die Lösung dieser Aufgabe wird durch den kennzeichnenden Teil des Anspruches beschrieben.

Darin wird die gegenseitige Verfahrbarkeit von Lötkopf und Bauelement, das sich auf der Leiterplatte befindet, zum Erzeugen einer Scherkraft ausgenutzt. Dieser Verfahrensschritt erfolgt nach dem Aufschmelzen des Lotes beim Auslöten eines Bauteiles von einer Leiterplatte.

Im folgenden wird anhand von schematischen Figuren ein Ausführungsbeispiel beschrieben.

Figur 1      zeigt eine Gesamtübersicht einer Ein- oder Auslötmaschine.

Figur 2      zeigt eine Zentrierbacke 16 und einen Anschlag 17, separiert vom Lötkopf 1 dargestellt.

Figur 3      zeigt eine Ausführung des Lötkopfes 1 mit zwei Zentrierbackenpaaren 23.

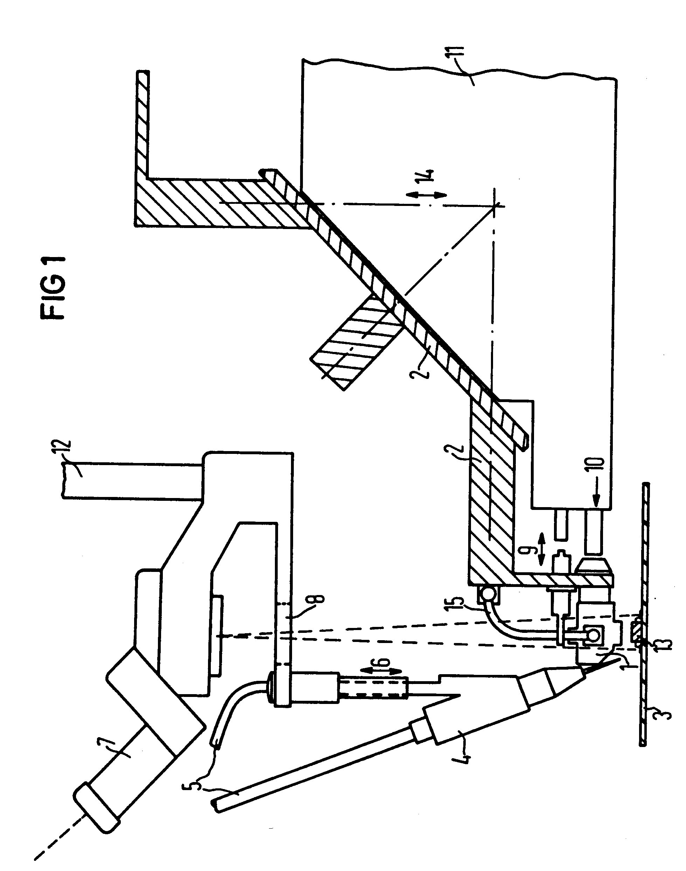

In Fig. 1 ist schematisch eine Ein- oder Auslötmaschine dargestellt. Sie enthält folgende wesentlichen Teile:

- den Lötkopf 1
- den Drehteller 2
- die Leiterplatte 3
- ein SMD-Bauelement 13
- eine Dosiervorrichtung 4 für Lotpaste mit
- Druckluftanschluß 5 und
- Hubzylinder 6, sowie
- Sichtfenster 8
- eine Optik 7, hier ein Mikroskop
- eine Stativ 12 für Optik 7 und Dosiervorrichtung 4
- ein Stativ 11 für den Drehteller 2 mit
- einer Hubeinrichtung 14
- eine Vakuumleitung 15
- einen Hubzylinder 9
- eine Heißgaszuführung 10.

Der am Drehteller 2 über einen Auslegearm befestigte Lötkopf 1 ist in seiner Arbeitsstellung derart positioniert und arretiert, daß mittels der Optik 7 das SMD-Bauelement 13 von oben durch das Sichtfenster 8 und durch den Lötkopf hindurch betrachtet werden kann. Durch Drehen des Drehtellers 2 können verschiedene an ihm über Auslegearme befestigte Lötköpfe bereit gestellt und in Arbeitsposition geschwenkt werden. Dargestellt ist lediglich ein zweiter Auslegearm, der jedoch nicht mit einem Lötkopf 1 versehen ist. Zum Ein- oder Auslöten wird über die Heißgaszuführung 10 dem Lötkopf 1 ein Heißgas zugeführt, daß im Lötkopf 1 auf die Anschlußbeine des SMD-Bauteils 13 geleitet wird und diese auf die nötige Löttemperatur von beispielsweise 210° oder 225° C erhitzt. Über den Hubzylinder 9 werden die im Lötkopf 1 enthaltenen Zentrierbacken betätigt, die das SMD-Bauelement 13 zeitweise zentrieren und festhalten. Eine weitere Halterung des SMD-Bauelementes 13 am Lötkopf 1 ist durch eine Vakuumeinrichtung gegeben, die über eine Vakuumleitung 15 versorgt wird. Die exakte Positionierung des Lötkopfes 1 relativ zu dem SMD-Bauelement 13 geschieht zum einen durch die in x/y-Richtung mögliche Verschiebung der Leiterplatte 3, sowie über die Hubeinrichtung 14, die den Lötkopf bezüglich der Höhe einstellt. Die Dosiervorrichtung 4 wird über die Druckluftanschlüsse 5 versorgt und durch den Hubzylinder 6 zum Aufbringen einer genau dosierten Menge von Lotpaste auf die Leiterplatte senkrecht nach oben oder nach unten bewegt. Auch hier ermöglicht die Optik 7 zusammen mit der senkrechten Betrachtungsweise durch den Lötkopf 1 hindurch eine parallaxen freie Betrachung des Ein- oder Auslötplatzes. Hierzu sind durch die Optik 7 in der Regel die Anschlußbeine des SMD-Bauteiles 13 sichtbar. Der zentral sitzende Körper des SMD-Bauteiles 13 ist durch die Vakuumeinrichtung verdeckt, die das Bauteil zeitweise hält.

Eine derartige Ein- oder Auslötmaschine für SMD-Bauteile 13 ist durch den Einsatz von Computerprogrammen automatisierbar. Hierzu sind drei wesentliche Arbeitsschritte zu benennen - das Auslöten, das Dosieren der Lotpaste, das Einlöten eines neuen SMD-Bauteiles.

Der Ablauf ist wie folgt:

### Auslöten

Über eine Grobjustierung wird der Lötkopf 1 ca. 20 mm über das SMD-Bauteil 13 gefahren und anschließend über eine Feinjustierung auf ca. 1 bis 2 mm angenähert und in x/y-Richtung ausgerichtet, so daß er direkt über dem Bauteil steht. Mittels des über den Lötkopf geführten Heißgases 10 werden die Anschlußbeine des SMD-Bauelementes 13 von Raumtemperatur mit einer Geschwindigkeit von etwa 1,5° C pro Sekunde bis auf ca. 200° C aufgeheizt. Anschließend wird der Lötkopf 1 auf das Bauelement 13 abgesetzt und das Vakuum, beispielsweise 1 mbar eingeschaltet, wodurch das Bauelement am Lötkopf angesaugt und gehalten wird. Während des nun einsetzenden eigentlichen Auslötprozesses wird innerhalb von 5 bis 15 Sekunden die Temperatur von 200 bis 210° C oder beispielsweise 225° C erhöht und das Lot zum Fließen gebracht. Der Lötkopf hebt anschließend mit dem Bauelement ab. Die angegebenen Zahlenwerte beziehen sich auf den Einsatz einer üblichen Lotpaste.

### Dosieren

Bei in Arbeitsposition eingeschwenktem oder auch ausgeschwenktem Lötkopf 1 wird übel die Dosiervorrichtung 4 eine exakt dosierte Menge Lotpaste auf die Anschlußflecken auf der Leiterplatte 3 aufgebracht. Dazu wird die Dosiervorrichtung 4 bis auf einen Abstand von ca. 1 bis 2 mm zur Leiterplatte 3 abgesenkt. Der Hubzylinder 6 sorgt für das Absenken einer Dosiernadel der Dosiervorrichtung 4. Die Menge der notwendigen Lotpaste kann über den Druck in der Druckluftzuführung 5, über die Zeit oder über den Durchmeserr der Dosiernadel gesteuert werden.

### Einlöten

Das Einlöten geschieht in entsprechender Weise wie das Auslöten. Das SMD-Bauelement 13 wird von dem Lötkopf 1 aufgenommen, mittels Zentrierbacken zentriert und über ein Vakuum festgehalten. Die Zentrierbacken sind in diesem Zustand wieder gelöst. Nach einer Grobpositionierung erfolgt das Absenken auf die Leiterplatte und die Feinjustierung, wobei mit der Opitk 7 kontrolliert wird. Innerhalb der ersten Phase des Aufheizens wird wiederum mit einer Geschwindigkeit von ca. 1,5° pro Sekunde bis auf ca. 200° C vorgeheizt und beispielsweise beim Einsatz einer handelsüblichen Lotpaste innerhalb von weiteren 5 bis 15 Sekunden auf ca. 225° C erhitzt. Die Halterung durch Ansaugen mittels Vakuum wird anschließend abgeschaltet, wobei gleichzeitig, um eine Nacherhitzung des Körpers der SMD-Bauteile 13 zu vermeiden, etwa 10 Sekunden lang kalte Luft direkt über die Vakuumleitung auf das SMD-Bauelement geblasen wird. Der Lötkopf 1 hebt nun ab und der Einlötvorgang ist beendet.

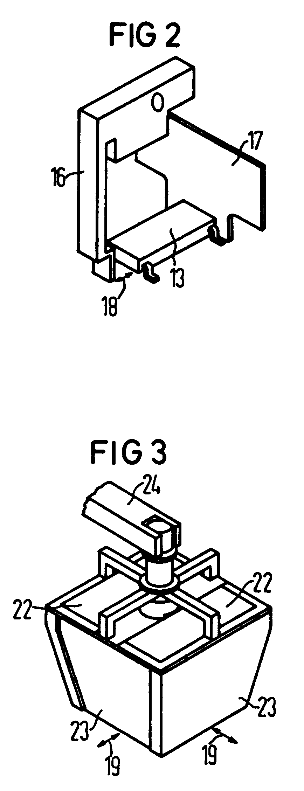

In Figur 2 ist eine mögliche Ausführung einer Zentrierbacke 16 dargestellt, die ein Bauelement 13 durch Annähern mittels einer Hubbewegung 18 an einen Anschlag 17 festhalten kann. Mit dieser konstruktiven Ausführung wird in der Regel die Scherkraft zum Abtrennen des aufgeklebten Bauelementes derart erzeugt, daß durch Verfahren der Leiterplatte 3 in x/y-Richtung die Scherkraft durch den Anschlag 17 erzeugt bzw. aufgenommen wird. Hierzu genügt ein ruckartiges Anfahren eines Arbeitstisches, in den die Leiterplatte 3 eingespannt ist. Der Lötkopf 1 mit Zentrierbacke 16 und Anschlag 17 steht in diesem Fall fest.

Die Figur 3 zeigt eine weitere Ausführung des Lötkopfes 1 mit einer Halterung 24, Sichtfenster 22, mit zwei Zentrierbackenpaaren 23 und deren zugehörigen Bewegungsrichtungen 19. Mit dieser konstruktiven Ausführung des Lötkopfes 1 wird je nach Verfahren der Leiterplatte in x/y-Richtung die Scherkraft durch eine der vier Zentrierbacken 23 erzeugt bzw. aufgenommen.

**Patentansprüche**

1. Verfahren zum Auslöten von oberflächenmontierbaren Bauelementen (SMD) (13), die neben einer Lötverbindung mit einer Leiterplatte (3) zusätzlich eine Klebeverbindung aufweisen, wobei über einen Lötkopf (1) zum Aufschmelzen der Lötverbindung Wärme in Richtung auf die Anschlußbeine der Bauelemente (13) zugeführt wird,

   **dadurch gekennzeichnet,**

   daß der Lötkopf (1) das oberflächenmontierte Bauelement (13) mit einem Anschlag (17) und einer Zentrierbacke (16; 23) oder zwei Zentrierbacken (16; 23) oder zwei Zentrierbackenpaaren (16; 23) greift und, nach dem Aufschmelzen der Lötverbindung, durch ruckartiges seitliches Verfahren zwischen der das Bauelement (13) tragenden Leiterplatte (3) und dem Lötkopf (1) relativ zueinander eine Scherkraft zum Abtrennen des Bauelementes (13) erzeugt wird.

**Claims**

1. Process for desoldering surface-mounted components (SMD) (13) which, in addition to a solder connection to a printed circuit board (3), additionally have a glued connection, heat being fed in the direction of the connecting legs of the components (13) via a solder head (1) in order to melt the solder connection, characterised in that the solder head (1) of the surface-mounted component (13) engages with a stop (17) and a centring jaw (16; 23) or two centring jaws (16; 23) or two pairs of centring jaws (16; 23) and, after the melting of the solder connection, by means of jolting lateral movement relative to one another between the printed circuit board (3) which bears the component (13) and the solder head (1) a shearing force is generated in order to disconnect the component (13).

**Revendications**

1. Procédé pour désouder des composant (SMD) (13) pouvant être disposés en surface et qui possèdent, en plus d'une liaison brasée les raccordant à une microplaquette à semiconducteurs (3), également une liaison collée, et selon lequel une chaleur est envoyée par l'intermédiaire d'une tête de brasage (1), afin de faire fondre la liaison brasée, en direction des pattes de raccordement des composants (13), caractérisé par le fait

   que la tête de brasage (1) saisit le composant (13) monté en surface par une butée (17) et une mâchoire de centrage (16;23) ou par deux mâchoires de centrage (16;23) ou par deux couples de mâchoires de centrage (16;23) et, après fusion de la liaison brasée, une force de cisaillement servant à séparer le composant (13) est produite par un déplacement latéral relatif brusque entre la plaquette à circuits imprimés (3) portant le composant (13) et la tête de brasage (1).

FIG 1

# FIG 2

# FIG 3